(19) Europäisches Patentamt
European Patent Office
Office européen des brevets

(11) **EP 3 583 004 B1**

(12) **EUROPÄISCHE PATENTSCHRIFT**

(45) Veröffentlichungstag und Bekanntmachung des Hinweises auf die Patenterteilung:
**07.04.2021 Patentblatt 2021/14**

(21) Anmeldenummer: **18703742.9**

(22) Anmeldetag: **02.02.2018**

(51) Int Cl.:
***B60R 16/03*** (2006.01)

(86) Internationale Anmeldenummer:
**PCT/EP2018/052628**

(87) Internationale Veröffentlichungsnummer:
**WO 2018/149663 (23.08.2018 Gazette 2018/34)**

(54) **SCHALTUNGSANORDNUNG ZUM DURCHFÜHREN EINES VERGLEICHS**

CIRCUIT ARRANGEMENT FOR CARRYING OUT A COMPARISON

CIRCUIT DESTINÉ À METTRE EN UVRE UNE COMPARAISON

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **14.02.2017 DE 102017202295**

(43) Veröffentlichungstag der Anmeldung:
**25.12.2019 Patentblatt 2019/52**

(73) Patentinhaber: **Robert Bosch GmbH**
**70442 Stuttgart (DE)**

(72) Erfinder:
• **NEUBERGER, Martin**
  **63820 Elsenfeld (DE)**
• **KOLLER, Oliver Dieter**
  **71384 Weinstadt (DE)**
• **BOHNE, Christian**
  **70437 Stuttgart (DE)**

(56) Entgegenhaltungen:
**EP-A2- 0 342 401          WO-A1-03/049970**
**DE-A1-102009 053 691     US-A1- 2012 292 984**

**Beschreibung**

Die Erfindung betrifft eine Schaltungsanordnung zum Durchführen eines Vergleichs und ein Verfahren zum Durchführen eines Vergleichs, welches insbesondere in einem Bordnetz eines Kraftfahrzeugs durchgeführt wird.

Stand der Technik

Unter einem Bordnetz ist insbesondere im automotiven Einsatz die Gesamtheit aller elektrischen Komponenten in einem Kraftfahrzeug zu verstehen. Somit sind davon sowohl elektrische Verbraucher als auch Versorgungsquellen, wie bspw. Generatoren oder elektrische Speicher, z. B. Batterien, umfasst. Im Kraftfahrzeug ist darauf zu achten, dass elektrische Energie so verfügbar ist, dass das Kraftfahrzeug jederzeit gestartet werden kann und während des Betriebs eine ausreichende Stromversorgung sichergestellt ist. Aber auch im abgestellten Zustand sollen elektrische Verbraucher noch für einen angemessenen Zeitraum betreibbar sein, ohne dass ein nachfolgender Start beeinträchtigt wird.

Zu beachten ist, dass aufgrund der zunehmenden Elektrifizierung von Aggregaten sowie der Einführung von neuen Fahrfunktionen die Anforderung an die Zuverlässigkeit der elektrischen Energieversorgung im Kraftfahrzeug stetig steigt. Weiterhin ist zu berücksichtigen, dass zukünftig bei einem hochautomatischen Fahren fahrfremde Tätigkeiten in begrenztem Maße zulässig sein sollen. Eine sensorische, regelungstechnische, mechanische und energetische Rückfallebene durch den Fahrer ist in diesem Fall nur noch eingeschränkt vorhanden. Daher besitzt bei einem hochautomatischen bzw. vollautomatisierten oder autonomen Fahren die elektrische Versorgung eine bisher in Kraftfahrzeugen nicht gekannte Sicherheitsrelevanz. Fehler im elektrischen Bordnetz müssen daher zuverlässig und möglichst vollständig erkannt werden.

Unter einem hochautomatischen Fahren, das auch als hochautomatisiertes Fahren bezeichnet wird, ist ein Zwischenschritt zwischen einem assistierten Fahren, bei dem der Fahrer durch Assistenzsysteme unterstützt wird, und einem autonomen Fahren, bei dem das Fahrzeug selbsttätig und ohne Einwirkung des Fahrers fährt, zu verstehen. Beim hochautomatischen Fahren verfügt das Fahrzeug über eine eigene Intelligenz, die vorausplant und die Fahraufgabe zumindest in den meisten Fahrsituationen übernehmen könnte. Daher hat bei einem hochautomatischen Fahren die elektrische Versorgung eine hohe Sicherheitsrelevanz. Energieversorgung und Verbraucher können daher redundant ausgeführt werden. Allerdings ist es nicht immer möglich, alle Verbraucher doppelt anzulegen. So kann bspw. der Airbag im Lenkrad nur einfach ausgeführt werden. Eine Versorgung aus zwei redundanten Energiequellen könnte daher zielführend sein.

Die Druckschrift DE 10 2009 053 691 A1 beschreibt ein Bordnetz sowie ein Verfahren und eine Vorrichtung zum Betreiben des Bordnetzes. Das Bordnetz umfasst einen Gleichspannungswandler und einen Basisenergiespeicher, der mit dem Gleichspannungswandler gekoppelt ist. Das Bordnetz umfasst weiterhin eine erste Auswahl von zumindest einem ersten elektrischen Verbraucher, der elektrisch parallel mit dem Gleichspannungswandler koppelbar ist, und eine zweite Auswahl von zumindest einem elektrischen Verbraucher, der elektrisch parallel mit dem Basisenergiespeicher koppelbar ist

Aus der WO 03/049970 A1 ist eine gattungsgemäße Schaltungsanordnung für eine Sitzbelegungserkennung bekannt.

In mehrkanaligen Bordnetzen stellt sich u. a. die Aufgabe, Verbraucher, insbesondere sicherheitsrelevante Verbraucher, sicher versorgen zu können. Die bekannten Lösungen nach dem Stand der Technik haben den Nachteil, dass bei einem Einfachfehler beide Bordnetze gekoppelt werden können.

Offenbarung der Erfindung

Vor diesem Hintergrund werden eine Schaltungsanordnung gemäß Anspruch 1 und ein Verfahren nach Anspruch 10 vorgestellt. Ausführungsformen ergeben sich aus den abhängigen Ansprüchen und aus der Beschreibung.

Die beschriebene Schaltungsanordnung dient dazu, einen Vergleich zwischen zwei Größen bzw. Signalen durchzuführen. Der Vergleich wird dabei unter Berücksichtigung einer Referenzgröße bzw. eines Referenzsignals durchgeführt. Dies bedeutet, dass die beiden Signale hinsichtlich dieses Referenzsignals beurteilt werden. Dabei kann das Signal der beiden Signale bestimmt werden, das näher bei dem Referenzsignal liegt. Die Schaltungsanordnung kommt insbesondere in einem Bordnetz eines Kraftfahrzeugs zum Einsatz. Ziel ist es, den Bordnetzkanal zur Versorgung zu wählen, der näher an der optimalen Versorgungsspannung einer Komponente liegt. Das Referenzsignal entspricht der optimalen Versorgungsspannung einer Komponente.

Das vorgestellte Verfahren ermöglicht in Ausgestaltung ein Ansteuern eines Koppelelements, das selbstsperrende und selbstleitende Leistungshalbleiter so miteinander kombiniert, dass ein Fail-Safe-Zustand für einen Kanal des Bordnetzes besteht. Hierzu wird die vorgestellte Schaltungsanordnung zum Durchführen eines Vergleichs eingesetzt.

Im Rahmen des Verfahrens ist weiterhin die gemeinsame Schaltungsauslegung der Ansteuerungslogik mit invertierter Auswirkung auf die zwei bzw. vier Schalter der Versorgungskanäle vorgesehen.

Es ist weiterhin eine gegenseitige hardwaretechnische Verriegelung beider Versorgungskanäle vorgesehen, um ein gleichzeitiges Schalten beider Kanäle zu vermeiden. Eine intelligente Wahl des zu versorgenden Kanals kann durch eine "fast-switching" analoge Logik gewährleistet werden. Ebenso wird eine interne Überwachung dieser Logik-Schaltung bereitgestellt, damit ein Fail-Safe-Zustand gewährleistet wird.

Durch eine integrierte Analogschaltung kann die Problematik des Toggeln zwischen zwei Versorgungskanälen eliminiert werden. Zudem kann mindestens einer von mindestens zwei Versorgungskanälen im Fehlerfall bereitgestellt werden. Außerdem wird per Schaltungsaufbau verhindert, dass beide Kanäle im Fehlerfall miteinander verkoppelt werden. Somit kann eine effiziente Versorgung der Verbraucher und damit ein Betrieb im Arbeitspunkt gewährleistet werden. Am konkreten Beispiel Airbag heißt dies, dass dieser auch dann mit elektrischer Energie versorgt werden kann, wenn der eine oder andere Versorgungskanal ausgefallen ist.

Weitere Vorteile und Ausgestaltungen der Erfindung ergeben sich aus der Beschreibung und den beiliegenden Zeichnungen.

Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Kurze Beschreibung der Zeichnungen

Figur 1 zeigt ein zweikanaliges Bordnetz nach dem Stand der Technik.

Figur 2 zeigt eine Schaltungsanordnung zum Versorgen eines Verbrauchers nach dem Stand der Technik.

Figur 3 zeigt eine Ausführung des vorgestellten Koppelelementes.

Figur 4 zeigt eine weitere Ausführung des vorgestellten Koppelelementes.

Figur 5 zeigt noch eine weitere Ausführung des vorgestellten Koppelelementes.

Figur 6 zeigt in einem Blockschaltbild eine Schaltungsanordnung zum Durchführen eines Vergleichs.

Figur 7 zeigt in einem Blockschaltbild eine Ausführung eines Vergleichers.

Figur 8 zeigt in einem Blockschaltbild eine alternative Schaltungsanordnung zum Durchführen eines Vergleichs.

Figur 9 zeigt die Verwendung von selbstleitenden und selbstsperrenden FETs.

Figur 10 zeigt in einem Schaltbild eine analoge Schaltung zur Durchführung eines Vergleichs.

Ausführungsformen der Erfindung

Die Erfindung ist anhand von Ausführungsformen in den Zeichnungen schematisch dargestellt und wird nachfolgend unter Bezugnahme auf die Zeichnungen ausführlich beschrieben.

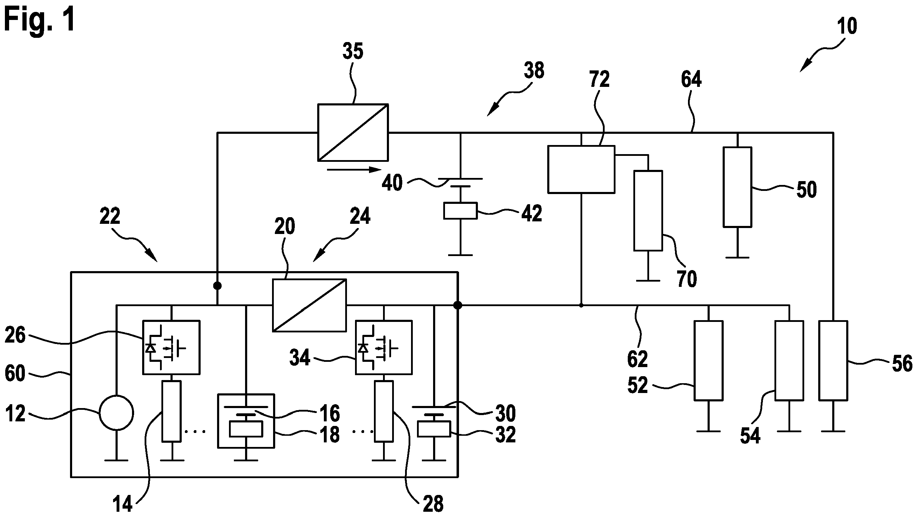

Figur 1 zeigt eine mögliche Ausführungsform eines zweikanaligen Bordnetzes nach dem Stand der Technik, das insgesamt mit der Bezugsziffer 10 bezeichnet ist. Dieses umfasst eine elektrische Maschine 12, bspw. einen Starter, einen ersten nicht sicherheitsrelevanten Verbraucher 14, eine erste Batterie 16, der ein Batteriemanagementsystem 18 zugeordnet ist, einen Gleichspannungswandler 20, der als Koppelelement zwischen einer Hochvoltseite 22, bspw. mit einem Spannungsniveau von 48 V, und einer Niedervoltseite 24, bspw. mit einem Spannungsniveau von 14 V, dient, eine erste electronic Power Distribution Unit 26 (ePDU: elektronische Energieversorgungseinheit), einen zweiten nicht sicherheitsrelevanten Verbraucher 28, eine zweite Batterie 30 mit zugeordnetem elektronischen Batteriesensor 32, eine zweite ePDU 34, einen zweiten Gleichspannungswandler 35, der als Koppelelement zwischen der Hochvoltseite 22 und einer weiteren Niedervoltseite 38, bspw. ebenfalls mit einem Spannungsniveau von 14 V, dient, eine dritte Batterie 40 mit zugeordnetem elektronischen Batteriesensor 42, einen ersten sicherheitsrelevanten Verbraucher 50, einen zweiten sicherheitsrelevanten Verbraucher 52, einen dritten sicherheitsrelevanten Verbraucher 54 und einen vierten sicherheitsrelevanten Verbraucher 56. Der dritte sicherheitsrelevante Verbraucher 54 und der vierte sicherheitsrelevante Verbraucher 56 sind zueinander redundant.

Mit einer Umrandung gekennzeichnet ist das Basisbordnetz 60 mit HV-Komponenten und 14 V-Komponenten ohne Sicherheitsrelevanz. In diesem Basisbordnetz 60 sind die erste Batterie 16 und die zweite Batterie 30 enthalten, einmal mit Hochvolt (HV), nämlich die erste Batterie 16, sowie mit Niedervolt (NV), nämlich die zweite Batterie 30.

An das Basisbordnetz 60 angekoppelt ist ein sicherheitsrelevanter Bordnetzkanal 62 mit den sicherheitsrelevanten Verbrauchern 52, 54, 56, wie bspw. Bremse, Lenkung usw. Es ist weiterhin ein zweiter sicherheitsrelevanter Kanal 64 vorgesehen. Da auch dieser die sicherheitsrelevanten Verbraucher 50 und 56 mit 14V versorgt, sind der zweite Gleichspannungswandler 35 und die zweite Batterie 40 vorgesehen.

Ein weiterer sicherheitsrelevanter Verbraucher 70 ist nur einmal vorhanden, kann aber über ein Koppelelement 72 wechselseitig aus einem der beiden Bordnetzkanäle 62 bzw. 64 redundant versorgt werden. In diesem Koppelelement 72 kann die vorgestellte Schaltungsanordnung zum Durchführen eines Vergleichs in Kombination mit Schaltern zum Einsatz kommen.

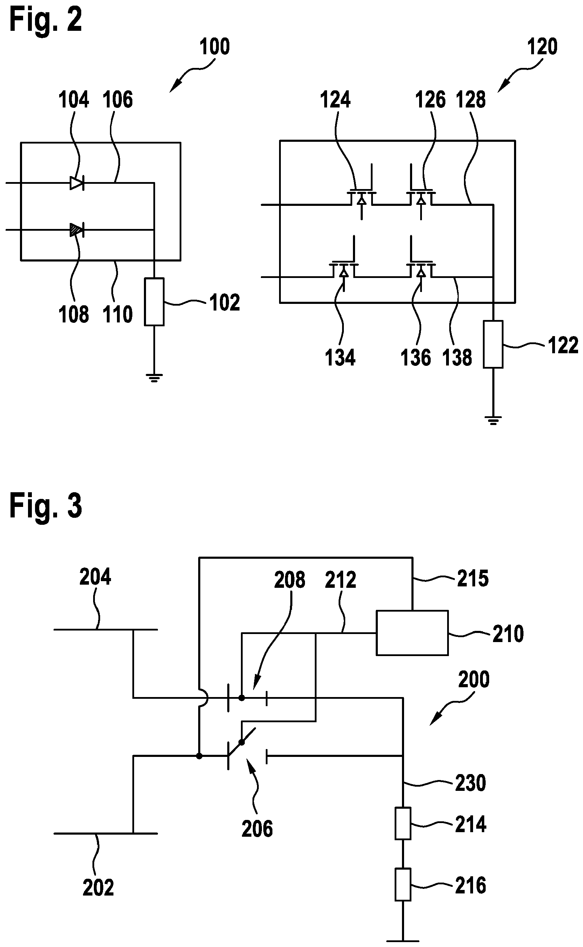

Nach dem Stand der Technik sind für dieses Koppelelement, das einen Umschalter realisiert, verschiedene Lösungen bekannt. Figur 2 gibt zwei bekannte Lösungen wieder.

Figur 2 zeigt auf der linken Seite eine erste Schaltungsanordnung 100, die ein Koppelelement verwirklicht und einen Verbraucher 102 ansteuert. Die Schaltungsanordnung 100 umfasst eine erste Diode 104 in einem ersten Bordnetzkanal 106 und eine zweite Diode 108 in einem zweiten Bordnetzkanal 110.

Auf der rechten Seite ist eine zweite Schaltungsanordnung 120 dargestellt, die ein Koppelelement verwirklicht und einen Verbraucher 122 ansteuert. Die Schaltungsanordnung 120 umfasst einen ersten Schalter 124 und einen zweiten Schalter 126, die in einem ersten Bordnetzkanal 128 angeordnet sind, sowie einen dritten Schalter 134 und einen vierten Schalter 136, die in einem zweiten Bordnetzkanal 138 angeordnet sind. Die Schalter 124, 126, 134, 136 können als MOSFETs ausgebildet sein.

In der ersten Schaltungsanordnung 100 ist das Koppelelement zu dem Verbraucher 102 somit über die Dioden 104, 108 ausgeführt. Je nachdem, welche Spannung höher ist, wird der Verbraucher 102 aus dem ersten Bordnetzkanal 106 oder dem zweiten Bordnetzkanal 110 versorgt. Dies hat den Nachteil, dass bei Überspannung in einem der Bordnetzkanäle 106 bzw. 110 der Verbraucher 102 nicht mehr betrieben werden kann. Dabei ist die Abschaltschwelle für Überspannung zu berücksichtigen. Die Dioden 104, 108 haben andererseits den Vorteil, dass keine aktive Ansteuerung benötigt wird. Weiterhin wird im Fall von Unterspannung in einem der Bordnetzkanäle 106 bzw. 110 der Verbraucher 102 unterbrechungsfrei aus dem anderen Bordnetzkanal 106 bzw. 110 versorgt.

Bei der zweiten Schaltungsanordnung 120 sind in jedem Bordnetzkanal 128, 138 zwei Schalter, bspw. Leistungshalbleiter, gegenläufig angeordnet. Dies wird als Back-to-Back-Verschaltung bezeichnet. Je nachdem, über welchen Bordnetzkanals 128 bzw. 138 der Verbraucher 122 versorgt werden soll, werden entweder der erste 124 und zweite Schalter126 bzw. der dritte 134 und vierte Schalter 136 angesteuert und so geschlossen.

Diese Lösung hat eine Reihe von Nachteilen:

1) Bei Ausfall der Ansteuerlogik des Koppelelements wird der Verbraucher 122 von beiden Bordnetzen 128 und 138 getrennt, da die Leistungshalbleiter unbestromt öffnen.

2) Durch Fehlansteuerungen können der erste Bordnetzkanal 128 und der zweite Bordnetzkanal 138 fälschlich verbunden werden.

Die bekannten Lösungen haben den Nachteil, dass bei einem Einfachfehler beide Bordnetze gekoppelt werden können. Ist bspw. eine der Dioden 104 in der ersten Schaltungsanordnung 100 durchlegiert, d. h. ständig leitend, kann dies nicht erkannt werden. Bei einer Überspannung in einem anderen Kanal mit der Diode 108 würde diese auf den ersten Kanal übersprechen, da die Diode 104 unerkannt leitend ist. Weiterhin kann bei einem Kurzschluss nach Masse im Verbraucher 102 dieser nicht vom ersten Kanal oder vom zweiten Kanal getrennt werden. Dadurch werden in jedem Fall beiden Kanäle durch den Kurzschluss beeinträchtigt.

Die zweite Schaltungsanordnung 120 hat den Nachteil, dass die Steuerung des Koppelelements, das durch die Schaltungsanordnung 120 gegeben ist, aktiv zwei Schalter schließen muss, um den Verbraucher 122 zu versorgen. Bei Ausfall der Steuerung kann der Verbraucher 122 nicht mehr versorgt werden. Gleichzeitig muss im Fall des Ausfalls eines Kanals sichergestellt werden, dass schnell genug auf den anderen, noch funktionierenden Kanal umgeschaltet wird, um den Verbraucher R2 unterbrechungsfrei zu versorgen. Die Ausführungsform hat weiterhin den Nachteil, dass durch Fehlansteuerungen der Schalter die beiden Kanäle miteinander verkoppelt werden können. Dies sollte aber in jedem Fall verhindert werden.

Es wird nunmehr vorgeschlagen, in einem Koppelelement einen Öffner und einen Schließer so miteinander zu kombinieren, dass die Vorteile von Dioden und Back-to-Back-Lösung kombiniert und die Nachteile eliminiert werden. Ein Öffner unterbricht den Stromfluss wenn er angesteuert wird. Der Schließer schließt den Kontakt wenn er angesteuert wird.

Figur 3 zeigt eine Ausführungsform eines Schaltelements, das insgesamt mit der Bezugsziffer 200 bezeichnet ist. Die Darstellung zeigt einen ersten Bordnetzkanal 202, einen zweiten Bordnetzkanal 204, einen Schalter S1 206, einen Schalter S2 208, eine Ansteuerung 210, die ein Ansteuersignal $O_1$ 212 ausgibt, eine Sicherung 214 und einen Verbraucher 216, der zu versorgen ist und sicherheitsrelevant ist. Über die Schalter S1 206 und S2 208 wird der Verbraucher 216 angesteuert, d. h. aus einem der beiden Bordnetzkanäle 202 bzw. 204 versorgt.

Das gezeigte Schaltelement 200, das im wesentlichen die Schalter S1 206 und S2 208 sowie die Ansteuerung 210 zusammen mit einer hier nicht dargestellten Logik, die durch eine hierin beschriebene Schaltungsanordnung zum Durchführen eines Vergleichs gegeben sein kann, bilden ein Koppelement, wie dieses bspw. für das in Figur 1 mit der Bezugsziffer 72 bezeichnet Koppelement eingesetzt werden kann.

Die Ansteuerung sieht wie folgt aus:

| $O_1$ | S1 | S2 |
|---|---|---|
| 0 | offen | zu |
| 1 | zu | offen |

Der Schalter S1 206 besteht aus einem Öffner, der Schalter S2 208 aus einem Schließer. Wie vorstehend beschrieben wurde, können Öffner und Schließer in einer Ausführungsform mithilfe von Leistungshalbleiter realisiert werden, z.B. als selbstsperrende und selbstleitende MOSFETs. Beide werden durch das gleiche Ansteuerungssignal $O_1$ 212 geschaltet. Dadurch wird sichergestellt, dass immer nur ein Schalter 206 oder 208 geschlossen sein kann.

Ist das Signal O1= Null/False, so ist der Schalter S1 206 offen und der Schalter S2 208 geschlossen. Der Verbraucher 216 wird dann über den zweiten Bordnetzkanal 204 versorgt.

Ist das Signal O1=1/true, so wird der Verbraucher 216 aus dem ersten Bordnetzkanal 202 versorgt. Die beiden Schalter 206, 208, die bspw. als Leistungshalbleiter ausgebildet sind, können mit der Sicherung 214, die bspw. als Schmelzsicherung ausgebildet ist, kombiniert werden. Diese kann in einer Versorgungsleitung 230 zum Verbraucher 216 angebracht sein und sorgt dafür, dass im Fall eines Kurzschlusses in dem Verbraucher 216 dieser von beiden Bordnetzkanälen 202, 204 getrennt wird. Aus Gründen der Stromtragfähigkeit können alternativ in beiden Bordnetzkanälen 202, 204 mehrere Öffner bzw. Schließer, typischerweise Leistungshalbleiter desselben Typs, parallel geschaltet werden. Ein serielles Anordnen mehrerer Öffner und Schließer desselben Typs ist ebenfalls denkbar. Die Schalter S1 206 und S2 208 stehen somit repräsentativ für eine Gruppe an Öffner bzw. Schließer desselben Typs, die in beliebiger Zahl parallel oder seriell angeordnet werden können.

Die Ansteuerung 210 wird bei dieser Ausführung über eine Leitung 215 aus dem ersten Bordnetzkanal 202 versorgt. Bei Ausfall des ersten Bordnetzkanals 202 und damit Ausfall der Ansteuerung bleibt der Schalter S2 208 als Schließer geschlossen und damit die Versorgung aus dem zweiten Bordnetzkanal 204 gewährleistet.

Zu beachten ist auch, dass das gezeigte Schaltelement 200 auch in einem Bordnetz mit mehr als zwei Kanälen angeordnet werden kann. In diesem Fall müssten Schließer und Öffner derart in den Bordnetzkanälen angeordnet sein, dass sichergestellt ist, dass immer ein Bordnetzkanal den Verbraucher versorgt.

Die dargestellte Ausführungsform hat den Vorteil, dass es keine Fehleransteuerung geben kann, die dazu führt, dass der erste Kanal 202 und der zweite Kanal 204 miteinander verkoppelt werden können. Bei Über- oder Unterspannung in einem der Bordnetzkanäle 202 bzw. 204 kann auf den jeweils anderen umgeschaltet werden. Fällt die Ansteuerung 210 aus, so schließt automatisch der Schalter S2 208 und der Schalter S1 206 öffnet. Der Verbraucher 216 wird dann aus dem zweiten Bordnetzkanal 204 versorgt.

In einer weiteren Ausführungsform wird jeweils eine Sicherung, bspw. eine Schmelzsicherung, direkt nach dem Schalter S1 und S2 und vor dem Verbindungspunkt der beiden Bordnetzkanäle angebracht. Dies hat den Vorteil, dass beim Kurzschluss in eine der Leitungen nach S1 oder S2 der Verbraucher weiterhin durch den jeweils anderen Bordnetzkanal versorgt werden kann.

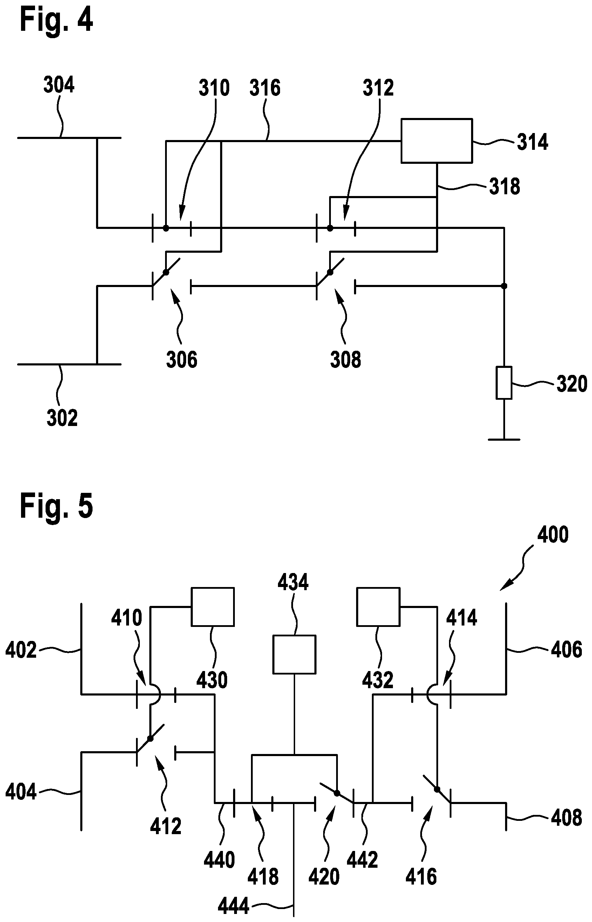

Figur 4 zeigt eine weitere Ausführungsform eines Schaltelements, das insgesamt mit der Bezugsziffer 300 bezeichnet ist. Die Darstellung zeigt einen ersten Bornetzkanal 302, einen zweiten Bordnetzkanal 304, einen Schalter S1 306, einen Schalter S3 308, einen Schalter S2 310, einen Schalter S4 312 eine Ansteuerung 314, die ein Ansteuersignal $O_1$ 316 und ein Ansteuersignal $O_2$ 318 ausgibt, und einen Verbraucher 320, der zu versorgen und sicherheitsrelevant ist. Die Kombination aus den Schaltern S1 306, S3 308, S2 310 und S4 312 wird über die Ansteuerung 314 angesteuert. Das Schaltelements 300, das im wesentlichen die Schalter S1 306, S3 308, S2 310 und S4 312 sowie die Ansteuerung 314 umfasst, bildet zusammen mit einer Logik, die durch eine Schaltungsanordnung zum Durchführen eines Vergleichs der hierin beschriebenen Art gegeben sein kann, ein Koppelelement, wie dieses bspw. für das in Figur 1 mit Bezugsziffer 72 bezeichnete Koppelelement eingesetzt werden kann.

Die Ansteuerung sieht wir folgt aus:

| $O_1$ | $O_2$ | S1 | S2 | S3 | S4 | Verbraucher |
|---|---|---|---|---|---|---|
| 0 | 0 | offen | zu | offen | zu | aus zweitem Kanal |
| 1 | 0 | zu | offen | offen | zu | getrennt |

(fortgesetzt)

| $O_1$ | $O_2$ | S1 | S2 | S3 | S4 | Verbraucher |
|---|---|---|---|---|---|---|
| 0 | 1 | offen | zu | zu | offen | getrennt |
| 1 | 1 | zu | offen | zu | offen | aus erstem Kanal |

Es werden somit nach dem gleichen Schema, wie dies in Figur 3 gezeigt ist, jeweils zwei selbstleitende (S2+S4) und zwei selbstsperrende Schalter (S1 und S3) kombiniert. Für die Ansteuerung der Schalter stehen zwei getrennte Ansteuersignale $O_1$ 316 und $O_2$ 318 als Ausgangssignale der Ansteuerung 314 zur Verfügung. Sind beide Ansteuersignale 316, 318 gleich Null, so wird der Verbraucher 320 aus dem zweiten Bordnetzkanal 304 versorgt. Sind beide Ausgangssignale gleich 1, so wird der Verbraucher 320 aus dem ersten Bornetzkanal 302 versorgt.

Für den Fall eines Kurzschlusses in dem Verbraucher 320 oder den Leitungen zu dem Verbraucher 320, werden die Ausgangsignale $O_1$ 316 und $O_2$ 318 verschiedenen ausgegeben. Dadurch ist in jedem Bordnetzkanal 302, 304 ein Schalter geschlossen und der andere im gleichen Bordnetzkanal 302, 304 geöffnet. Der Verbraucher 320 kann dadurch von beiden Bordnetzkanälen 302, 304 getrennt werden.

Auch diese Ausführungsform hat den Vorteil, dass auch bei fehlerhafter Ansteuerung niemals beide Bordnetzkanälen 302, 304 miteinander verkoppelt werden können. Auch bei Ausfall der Ansteuerung 314 wird der Verbraucher 320 automatisch durch die selbstleitenden Schalter aus dem zweiten Bordnetzkanal 304 versorgt. Ggf. ist es sinnvoll, die Schalter gegenläufig, d. h. back-to-back anzuordnen, um eine Leitung durch eine parasitäre Diode auszuschließen.

In einer weiteren Ausführungsform sind die Schließer im ersten Bornetzkanal angeordnet und die Öffner im zweiten Bordnetzkanal. Dadurch wird bei Ausfall der Ansteuerung der Verbraucher automatisch aus dem ersten Bordnetzkanal versorgt. Auch hier gilt, wie bei der Ausführungsform der Figur 3, dass Öffner und Schließer in einer Ausführungsform mithilfe von Leistungshalbleiter realisiert werden, bspw. durch selbstsperrende und selbstleitende MOSFETs.

Ein serielles Anordnen mehrerer Öffner und Schließer desselben Typs ist auch bei dem Schaltelement 300 der Figur 4 denkbar. Die Schalter S1, S2, S3 und S4 stehen somit repräsentativ für eine Gruppe an Öffner bzw. Schließer desselben Typs, die in beliebiger Zahl parallel oder seriell angeordnet werden können.

Die Anzahl n der Öffner in einem Bordnetzkanal entspricht der Anzahl n der Schließer in dem anderen Bordnetzkanal. In diesem Fall sind auch n Ansteuersignale bereitgestellt, von denen jedes jeweils einen Öffner und einen Schließer gemeinsam ansteuert.

Allen Ausführungsformen ist gemein, dass die jeweils symmetrisch gespiegelte Variante des Umschalters, d. h. alle Schließer und Öffner aus dem ersten Bordnetzkanal werden in den zweiten Bordnetzkanal verschoben und umgekehrt, ebenfalls eine mögliche Ausführung ist.

Die Schalter S1 bis S4 können durch geeignete Leistungshalbleiter realisiert werden. Dies können bspw. p-Kanal oder n-Kanal MOSFETs sein. Von Bedeutung sind die gegenläufige Verwendung von Öffnern und Schließern und eine gemeinsame Ansteuerleitung, die zu invertiertem Verhalten führt.

In einer weiteren Ausführungsform wird das Schaltelement bzw. Koppelelement dazu benutzt, um bspw. einen Spannungswander sowohl aus der Ausgangsseite als auch aus der Eingangsseite zu versorgen. Dies hat den Vorteil, dass der Wandler auch bei Ausfall, bspw. bei Unter- oder Überspannung, in einem der Bordnetzkanäle weiterhin aktiv bleiben kann.

Figur 5 zeigt eine Ausführung eines Schaltelements 400, das wiederum zusammen mit einer nicht dargestellten Logik ein Koppelement bildet, mit einem ersten Kanal 402, einem zweiten Kanal 404, einem dritten Kanal 406 und einem vierten Kanal 408. In dem ersten Kanal 402 ist ein Schließer 410, in dem zweiten Kanal 404 ein Öffner 412, in dem dritten Kanal 406 ein Schließer 414 und in dem vierten Kanal 408 ein Öffner 416 angeordnet. In einem Kanal 440, der den ersten Kanal 402 und den zweiten Kanal 404 kombiniert, ist ein Schließer 418 und in einem Kanal 442, der den dritten Kanal 406 und den vierten Kanal 408 kombiniert, ist ein Öffner 420 angeordnet.

Ein erstes Ansteuersignal 430 steuert gemeinsam den Schließer 410 und den Öffner 412 an, ein zweites Ansteuersignal 432 steuert gemeinsam den Schließer 414 und den Öffner 416 an, ein drittes Ansteuersignal 434 steuert gemeinsam den Schließer 418 und den Öffner 420 an. So ist sichergestellt, dass ein Verbraucher (nicht dargestellt) über einen Ausgang 444 immer versorgt ist.

Zur Erläuterung eines Verfahrens zum Koppeln wird nochmals Bezug genommen auf die Schaltungsanordnung 120 der Figur 2. Bei dieser werden zwei Schalter 124 und 126 bzw. 134 und 136 geschlossen, um den Verbraucher 122 zu versorgen.

Es ist zu berücksichtigen, das die Schalter bzw. Umschaltelemente nicht zu oft angesteuert werden dürfen, um ein Toggeln zu vermeiden. Die Spannung in einem Kanal R würde dann zu oft schwanken und das Schalten würde Rückwirkungen auf die redundanten Kanäle haben. Dies bedeutet, dass mit jedem Umschalten der Kanal, auf den geschaltet wird, belastet wird. Hierdurch kann die Spannung einbrechen. Dies wiederum verursacht ein Umschalten auf den anderen Kanal. Dessen Spannung könnte durch die Umschaltung ebenfalls einbrechen, so dass durch diese Mitkopplung ein permanentes Umschalten verursacht wird. Dies soll durch das vorgestellte Verfahren vermieden werden.

Hierzu wird eine schnelle und eigensichere Einrichtung zur Ansteuerung der oben erwähnten Halbleiter im Koppelelement 72 in Figur 1 vorgeschlagen.

Dabei ist vorgesehen, im Schaltelement 400 selbstsperrende und selbstleitende Leistungshalbleiter so miteinander zu kombinieren, dass ein Fail-Safe-Zustand für einen Kanal des Bordnetzes besteht. Dabei kann weiterhin die gemeinsame Schaltungsauslegung der Ansteuerungslogik mit invertierter Auswirkung auf die zwei bzw. vier Schalter der Versorgungskanäle vorgesehen sein. Es kann des Weiteren eine gegenseitige hardwaretechnische Verriegelung beider Versorgungskanäle vorgenommen werden, um ein gleichzeitiges Schalten beider Kanäle zu vermeiden. Zudem kann weiterhin eine intelligente Wahl des zu versorgenden Kanals durch eine sogenannte "fast-switching" analoge Logik gewährleistet werden. Ebenso kann eine interne Überwachung dieser Logik-Schaltung bereitgestellt sein, damit ein Fail-Safe-Zustand gewährleistet wird.

Ein Toggeln zwischen zwei Versorgungskanälen kann dabei durch eine integrierte Analogschaltung eliminiert werden. Im Fehlerfall kann mindestens einer der beiden Versorgungskanäle bereitgestellt werden. Außerdem kann per Schaltungsaufbau verhindert werden, dass beide Kanäle im Fehlerfall miteinander verkoppelt werden. Somit kann eine effiziente Versorgung der Verbraucher, insbesondere auch ein Betrieb am Arbeitspunkt, sichergestellt werden.

Das in Verbindung mit den Figuren 3 bis 5 beschriebene Verfahren zum Koppeln hat den Vorteil, dass der Verbraucher 70 in Figur 1 auch bei Ausfall der Steuerung des Koppelelements 72 weiterhin versorgt wird. Die Vorteile der Dioden werden also übernommen. Gleichzeitig können Kurzschlüsse im Verbraucher 70 aktiv getrennt werden.

In den folgenden Darstellungen werden nunmehr Ausführungen der Schaltungsanordnung zum Durchführen eines Vergleichs vorgestellt, wie diese bspw. zusammen mit den in den Figuren 3 bis 5 gezeigten Schaltelementen ein Koppelelement bilden können. Es sind aber auch andere Einsätze der vorgestellten Schaltungsanordnungen zum Durchführen eines Vergleichs und des nachstehend erläuterten Verfahrens zum Durchführen eines Vergleichs denkbar.

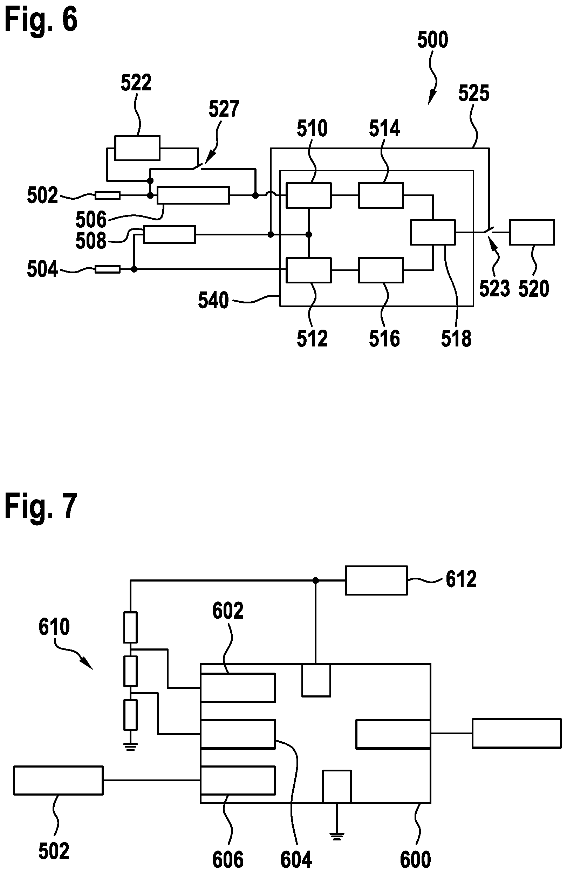

Figur 6 zeigt in einem Blockschaltbild eine Schaltungsanordnung 500 zur Durchführung eines Vergleichs, die bspw. im Rahmen einer Versorgung von sicherheitskritischen Verbrauchern mittels einer redundanten Bordnetztopologie aus zwei Kanälen mit einer intelligenten Versorgungskanal-Auswahl gemäß dem vorgestellten Verfahren eingesetzt werden kann. Die gezeigte Schaltungsanordnung 500 ist ausschließlich mit analogen Bauteilen aufgebaut. Diese entspricht den Ansteuerelementen 210 bzw. 314 bzw. 430, 432, 434.

Die Darstellung zeigt einen ersten Kanal 502, einen zweiten Kanal 504, einen ersten Gleichspannungswandler 506, der hierin auch als Toggle-Gleichspannungswandler bezeichnet wird, einen zweiten Gleichspannungswandler 508, der hierin auch als Referenzgleichspannungswandler bezeichnet wird, einen ersten Differenzenverstärker 510, einen zweiten Differenzenverstärker 512, eine erste Einheit 514 zum Bilden eines Betrags, eine zweite Einheit 516 zum Bilden eines Betrags, einen Komparator 518 und einen Vergleicher 522. Der Schaltungsanordnung 500 ist eine Ansteuerung 520 mit Feldeffekttransistoren (FET) zum Ansteuern von Schaltern eines Schaltelements, wie dieses bspw. in den Figuren 3 bis 5 dargestellt ist, zugeordnet.

In Figur 6 ist die grundlegende Gesamt-Topologie der Schaltungsanordnung 500 zum Vergleichen zusammen mit einer Ansteuerung 520 dargestellt. Diese Schaltungsanordnung 500 zusammen mit einem in Figuren 3 bis 5 gezeigten Schaltelement bildet ein Koppelelement. Es sind aber auch andere Einsatzmöglichkeiten für die Schaltungsanordnung 500 denkbar. Die Schaltungsanordnung 500 gewährleistet somit in einer möglichen Anwendung die Ansteuerung von Schaltern zur Versorgung von sicherheitskritischen Verbrauchern mittels einer redundanten Bordnetztopologie aus Kanal-A oder Kanal-B mit intelligenter Versorgungskanal-Auswahl.

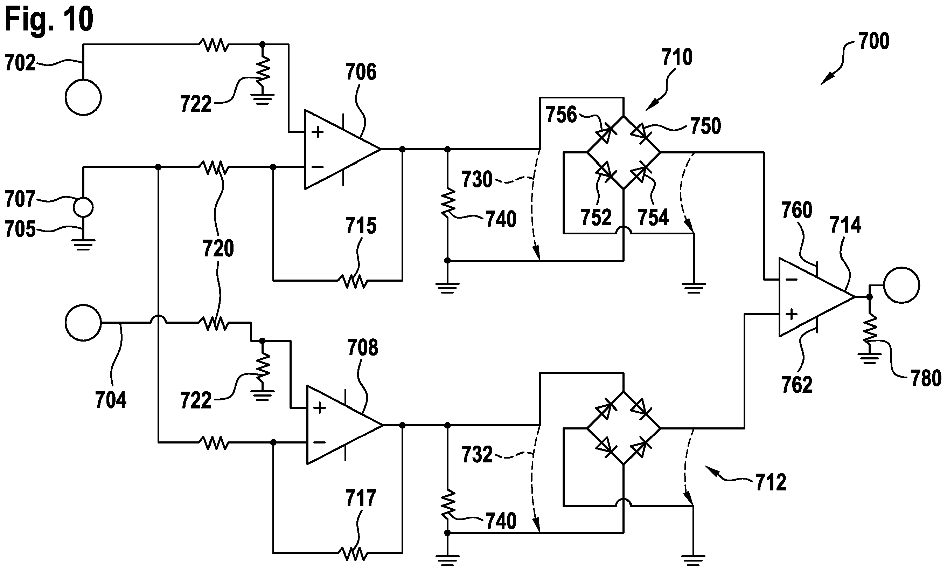

In der Schaltungsanordnung 500, die eine Logikschaltung darstellt, werden zwei Gleichspannungswandler 506, 508 eingesetzt. Eine Gleichspannungsreferenz wird benötigt, um eine Referenz-Spannung von 13,5 V für die analoge Ansteuerungsschaltung bereitzustellen. Hiermit ist es möglich, die Spannungseben von dem ersten Kanal und dem zweiten Kanal in der analogen Ansteuerungseinrichtung 520 auszuwerten und den bestmöglichen Versorgungskanal zu bestimmen. Der bestmögliche Kanal ist in erster Näherung der, der am nächsten an 13,5 V liegt. Ein mit Bezugsziffer 540 bezeichneter Rahmen umrahmt die Schaltung, die in Figur 10 im Detail dargestellt ist.

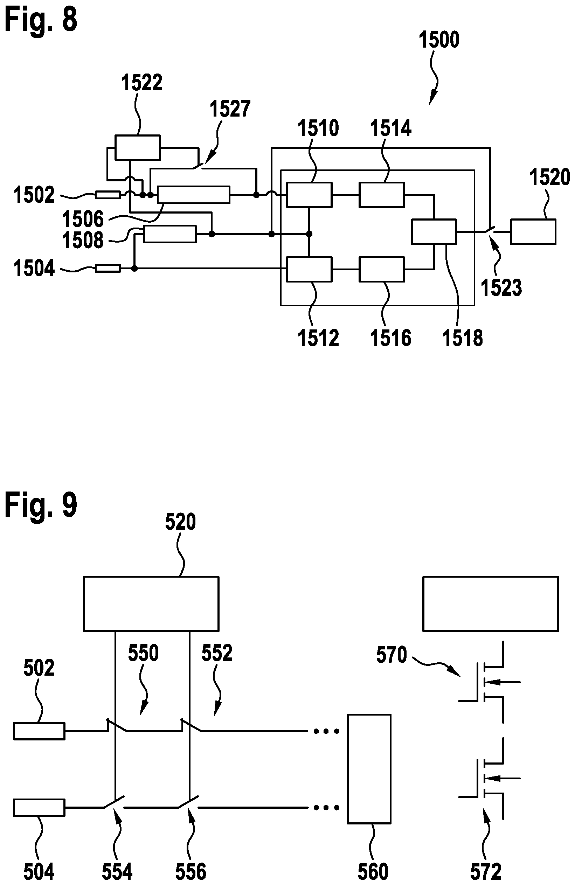

Die Ansteuerung der FETs erfolgt aus dem Komparator 518. Der mit diesem durchgeführte Vergleich überprüft, ob der Betrag aus 514 oder 516 größer ist. Dabei muss die Ansteuerung 520 der FETs zu den Bauelementen aus Figur 9 passen. Sollen die Verbraucher aus dem ersten Kanal 502 versorgt werden, muss der Komparator 518 eine 0 ausgeben, da im ersten Kanal 502 selbstleitende, d. h. im nicht betätigten Zustand leitende, FETs (in Figur 9 550, 552) vorgesehen sind.

Sollen die Verbraucher aus dem zweiten Kanal 504 versorgt werden, muss der Komparator eine 1 ausgeben, da im zweiten Kanal selbstsperrende, d. h. im nicht betätigten Zustand unterbrochene, FETs vorgesehen sind (in Figur 9 554, 556). Ein Schalter 523 in Figur 6 hat die Aufgabe, bei Ausfall des Referenzspannungswandlers 508 das Ansteuersignal 520 = 0 zu setzen und damit auf den ersten Kanal 502 zu schalten. D. h. es erfolgt keine Ansteuerung und der erste Kanal 502 ist selbstschließend. Daher liegt eine Verbindung 525 vom Gleichspannungswandler 508 zum Schalter 523 vor und es wird auch der Gleichspannungswandler 508 aus dem zweiten Kanal 504 versorgt. Fällt der zweite Kanal 504 aus, wird der Schalter 523 am Ende geöffnet und die Verbraucher werden immer aus dem ersten Kanal 502 versorgt.

Die mit dem Rahmen 540 bezeichnete Vergleichsschaltung umfasst zwei Differenzverstärker 510, 512, welche die Eingangsspannungen der Kanäle 502, 504 mit der Referenzspannung vergleichen. Diese wird in dem Referenzgleichspannungswandler 508 gebildet. Da die Abweichung auch negativ sein kann, wird nachfolgend der Betrag in 514 bzw. 516 gebildet. Der Kanal mit der absolut kleinsten Abweichung gegenüber der Referenzspannung wird dann für die Versorgung der sicherheitsrelevanten Verbraucher genutzt.

Für den Fall, dass sowohl der erste Kanal 502 als auch der zweite Kanal 504 nahe beieinanderliegen, bspw. nahe 13,5 V, würde durch die im Bordnetz ständig vorhandenen Spannungsschwankungen ein ständiges, unnötiges Toggeln durch wechselnde Ansteuerung der Schalter hervorgerufen werden. Dieses Toggeln belastet durch Spannungsschwankungen das Bordnetz sowie dessen Verbraucher und sollte daher vermieden werden. Hierzu wird der Toggle-Gleichspannungswandler 506 eingeführt, der den Eingang des Differenzverstärkers 510 bildet. Da der Ausgangswert des Gleichspannungswandlers 506 gleich dem des Gleichspannungswandlers 508 ist, wird immer der erste Kanal 502 zur Versorgung der sicherheitsrelevanten Verbraucher genutzt. Erst wenn die Spannung im ersten Kanal 502 signifikant abweicht, wird ein Schalter 527 über den Gleichspannungswandler 506 geschlossen. Signifikant heißt in diesem Fall bspw. mehr als 1 V.

Dazu hat der Vergleicher 522 zwei Eingänge, nämlich den ersten Kanal 502 und eine Versorgungsspannung (nicht dargestellt). Erst wenn die Spannung von dem ersten Kanal 502 um einen Schwellwert > x, bspw. 1 V, von dem Sollwert abweicht, wird am Ausgang = 1 von dem Vergleicher 522 ausgegeben und somit der Schalter 527 geschlossen.

Figur 7 zeigt einen möglichen Aufbau des Vergleichers (Bezugsziffer 522 in Figur 6), der hier mit Bezugsziffer 600 bezeichnet ist. Zu beachten ist, dass der Vergleicher 522 auch den Spannungsteiler 610 enthält, d. h. die Eingänge des Vergleichers 522 sind strenggenommen 612 und 502. Der Vergleicher 600 ist ein Komparatorbaustein mit drei Eingängen 602, 604, 606, d. h. zwei Schwellenspannungen (Eingänge 602 und 604) und dem ersten Kanal 502 am dritten Eingang 606. Durch jeweils einen Spannungsteiler 610 mit Abgriff von der Versorgungsspannung VCC 612 des Komparators werden die Schwellen an dem Vergleicher 600 eingestellt, hier z. B. 12,5 V und 14,5 V. Der Komparator des Vergleichers 600 hat somit drei Eingänge, nämlich untere Schwelle bei 602, obere Schwelle bei 604 und Ist-Wert bei 606. Befindet sich der Spannungspegel des ersten Kanals 502 innerhalb dieses Bereichs, ist der Schalter (Bezugsziffer 527 in Figur 6) nach dem Vergleicher 600 (Bezugsziffer 522 in Figur 6) offen. Dies bedeutet, dass der erste Kanal den Gleichspannungswandler 506 in Figur 6 versorgt. Da der Gleichspannungswandler 506 z. B exakt 13,5 V liefert, was mit der Spannung des Referenzgleichspannungswandlers 508 übereinstimmt, gibt die Komparatorschaltung des Vergleichers 600 eine Versorgung aus dem ersten Kanal 502 frei. Die Versorgung des Komparators sollte in geeigneter Weise sichergestellt werden. Möglich hierfür ist: Der Komparator des Vergleichers 600 hat dieselbe positive Versorgungsspannung wie der Ausgangskomparator 518 aus Figur 6. Alternativ kann die Versorgung von einer externen Komponente mit entsprechender ASIL-Einstufung erfolgen.

Figur 8 zeigt eine zu Figur 6 alternative Ausführung der Schaltungsanordnung, die insgesamt mit der Bezugsziffer 1500 bezeichnet ist. Die Darstellung zeigt einen ersten Kanal 1502, einen zweiten Kanal 1504, einen ersten Gleichspannungswandler 1506, einen zweiten Gleichspannungswandler 1508, einen ersten Differenzenverstärker 1510, einen zweiten Differenzenverstärker 1512, eine erste Einheit 1514 zum Bilden eines Betrags, eine zweite Einheit 1516 zum Bilden eines Betrags, einen Komparator 1518 und einen Vergleicher 1522. Der Schaltungsanordnung 1500 ist eine Ansteuerung 1520 mit Feldeffekttransistoren (FET) zum Ansteuern von Schaltern eines Schaltelements, wie dieses bspw. in den Figuren 3 bis 5 dargestellt ist, zugeordnet. Es sind weiterhin ein erster Schalter 1523 und ein zweiter Schalter 1527 gezeigt.

Im Vergleich zu der Ausführung in Figur 6 ist der Vergleicher 1522 an den ersten Kanal 502 und den Referenzgleichspannungswandler 1508 angeschlossen. Es wird in diesem Fall überprüft, ob der Betrag von (U_erster Kanal 1502 - U_Referenzspannung) bspw. < 1 V ist, d. h. ob die Ausgangsspannung des ersten Kanals 1502 nahe am Referenzwert ist. Auch dies wird mit dem gleichen Ziel durchgeführt: Ist U_erster Kanal 1502 nahe am Referenzwert, z. B. 13,5 V, soll, um ein Toggeln zu verhindern, der Schalter 1527 geöffnet sein und somit die Ausgangsspannung des Gleichspannungswandlers 1506 in den Differenzverstärker 1510 eingehen. Der interne Aufbau des Vergleichers 1522 unterscheidet sich dann von dem in Figur 7 gezeigten Aufbau.

Figur 9 zeigt die Verwendung von selbstleitenden und selbstsperrenden FETs. Die Darstellung zeigt auf der linken Seite die Ansteuerung 520 aus Figur 6 mit dem ersten Kanal 502 und dem zweiten Kanal 504 sowie einen ersten selbstleitenden FET 550, einen zweiten selbstleitenden FET 552, einen ersten selbstsperrenden FET 554, einen zweiten selbstsperrenden FET 556 sowie einen Verbraucher 560. Auf der linken Seite ist zur Verdeutlichung das Schaltsymbol eines selbstlernenden FET 570 und eines selbstsperrenden FET 572 wiedergegeben.

In Figur 10 ist eine Ausführung einer analogen Ansteuereinrichtung, insgesamt mit Bezugsziffer 700 versehen, dargestellt, die eine Schaltungsanordnung gemäß Figur 6 verwirklicht. Die Darstellung zeigt einen ersten Kanal 702, einen zweiten Kanal 704 und einen Eingang 705 für eine Referenzspannung, die von einer Spannungsquelle 707 bereitgestellt wird. Weiterhin sind ein erster Differenzverstärker 706, ein zweiter Differenzverstärker 708, die als Operationsverstärker ausgebildet sind, und eine erste Einheit 710 zum Bilden eines Betrags und eine zweite Einheit 712 zum Bilden eines Betrags, die jeweils als Diodengleichrichter ausgebildet sind, vorgesehen. Am Ausgang befindet sich ein Komparator 714. Die Spannungsquelle 707 liegt mitten in dem Spannungsbereich, in dem die Komponenten versorgt werden sollen, vorzugsweise in der Mitte des Bereichs.

Widerstände R1 720 und R2 722 haben die Aufgabe, den Eingangsstrom in der Schaltungsanordnung 700 zu begrenzen und somit das Bordnetz nicht zu belasten. Die Werte liegen typischerweise im Bereich von 100 kOhm. Die Differenzverstärker 706 und 708 bilden jeweils die Differenz zwischen der jeweiligen Eingangsspannung und der Referenzspannung. Ausgangsspannung ist Ux 730 bzw. Uy 732. Die Widerstände R3 740 haben ebenfalls die Aufgabe, die fließenden Ströme zu begrenzen. Die Werte liegen im Bereich von 100 kOhm. Die Auslegung ist abhängig vom verwendeten Komparator 714. Widerstände R4 715 und 717 liegen im Bereich von 100 kOhm und dienen dazu, den Eingangsstrom zu begrenzen.

Die Diodengleichrichter 710, 712 haben die Aufgabe, mathematisch den Betrag zu bilden. Ist die Spannung Ux 730 positiv, fließt der Strom über D1 750 und D3 752. Ist der Ux 730 negativ, so fließt der Strom über D2 754 und D4 756. Die jeweils anderen Dioden sperren. Aufgrund der hohen Widerstände fließen im energetischen Sinne jedoch keine nennenswerten Ströme, sondern eher "Signale".

Der Komparator 714 hat die Aufgabe, das Ansteuersignal für die Leistungshalbleiter zu generieren. Dazu liegt am oberen Anschluss 760 die Versorgungsspannung, die typischerweise von einer externen, unabhängigen Einheit bereitgestellt wird, und am unteren Anschluss 762 Masse an. Ist Ux 730 kleiner als Uy 732, wird der Ausgang durchgeschaltet. Ist Ux 730 größer als Uy 732, ist der Ausgang gleich null. Über einen Widerstand R5 780 entsteht der Spannungsabfall, an den high oder low gemessen wird. Dieser ist nicht unbedingt erforderlich, insbesondere ist dies abhängig von der Endschaltung. Werte liegen im Bereich von 10 bis 100 kOhm.

Die Ansteuereinrichtung 520 aus Figur 6 ist fail-safe ausgelegt, so dass in jedem Fall eine Versorgung aus einem Kanal bereitgestellt werden kann. Bei einem Fehler im zweiten Kanal wird aufgrund der selbstleidenden Halbleiterbauteile aus Figur 74, die Versorgung aus dem ersten Kanal sichergestellt. Bei einem Fehler in dem zweiten Kanal wird mittels der Schaltungsanordnung 700 aus Figur 10 und mittels eines Schaltelements die Versorgung aus dem zweiten Kanal sichergestellt. Grundlegend stellt der erste Kanal die Versorgung des ersten Gleichspannungswandlers 506 und der zweiten Kanal die Versorgung des Referenzspannungs-Gleichspannungswandlers 508 bereit.

Im Detail bedeutet dies bei Ausfall des Gleichspannungswandlers des ersten Kanals, mittels der Schaltung aus Figur 8 der Komparator die Ansteuerung der FETs aus dem zweiten Kanal veranlasst. Somit versorgt der zweiten Kanal die Verbraucher. Bei Ausfall des Gleichspannungswandlers 508 des zweiten Kanals wird mittels der Schaltung aus Figur 10 die Versorgung aus dem ersten Kanal veranlasst.

Ein weiterer Vorteil der Ansteuereinrichtung ist die Vermeidung eines ständigen bzw. toggelnden Umschaltens der Versorgungskanäle. Hierzu wurde auf analogem Weg eine Hystereseschaltung implementiert, welche die Spannungsebene des ersten Kanals 502 anhand festgelegter Schwellwerte vergleicht. Die Werte sind beispielshaft gewählt.: Wenn: (Uref < 12,5 V) v (Uref > 14,5 V) -> Dann: Schalter 527 schließen

Befindet sich der Spannungspegel des ersten Kanals 502 außerhalb dieses Wertebereichs, wird der erste Gleichspannungswandler 506 des ersten Kanals durch Schließen des Schalters 527 überbrückt (siehe Figur 9). Dies hat zur Folge, dass durch die Schaltungsanordnung aus Figur 8 geprüft wird, ob die Spannungsebene vom ersten Kanal oder vom zweiten Kanal näher am Referenzwert (13,5V) liegt. Je nach Spannungslage versorgt der erste Kanal oder der zweite Kanal die Verbraucher. Hierdurch wird eine intelligente Auswahl des Versorgungskanals gewährleistet.

Befindet sich der Spannungspegel des ersten Kanals 502 innerhalb dieses Bereiches, besteht die Gefahr des Toggelns. dieses Problem wird durch den ersten Gleichspannungswandler 506 aus dem ersten Kanal A gelöst. Dieser stellt konstant dieselbe Spannung wie die Gleichspannungsreferenz bereit, bspw. 13,5 V. Die nachfolgende Differenzenverstärker-Schaltung im Strang des ersten Kanals liefert folglich = null. Somit wird die Versorgung der Verbraucher aus dem ersten Kanal priorisiert, da der erste Kanal näher an der Referenzspannung liegt (U CH-A = U REF). Die Komparator-Auswertung 518 liefert keine Ansteuerung, folglich versorgt der erste Kanal A die Verbraucher.

Diese Ausführungsform hat den Vorteil, dass ein Ausfall des Referenzspannungs-Gleichspannungswandlers 508 aus Figur 6 abgefragt wird und im Zweifel den priorisierten fehlerfreien ersten Kanal schaltet, da dieser mit selbstleitenden FETs ausgeführt ist. Ebenso besteht der Vorteil, dass ein Fehlerfall des Gleichspannungswandlers 508 bei Über- oder Unterspannung, durch einen Vergleich (Vergleicher 522) gemäß Figur 6 abgefragt wird und im Zweifel den priorisierten fehlerfreien ersten Kanal schaltet.

Wenn der Gleichspannungswandler 508 ausfällt, dann besteht die erhöhte Wahrscheinlichkeit, dass ein Fehler in dem zweiten Kanal besteht, da der Gleichspannungswandler 508 von dem zweiten Kanal aus versorgt wird. Durch den Vergleich (Vergleicher 522) wird somit der Überbrückungsschalter des ersten Gleichspannungswandlers 506 gebrückt und die Versorgung aus dem ersten Kanal gewährleistet.

In Figur 9 ist der Laststrang zu den (sicherheitskritischen) Verbrauchern gezeigt. Im ersten Kanal befinden sich zwei selbstleitende (NC) Leistungshalbleiter (Bspw. N-type IG-FET). Im zweiten Kanal hingegen zwei selbstsperrende (NO) Leistungshalbleiter (Bsp. N-type MOSFET). Beide werden durch das gleiche Ansteuerungssignal "Ansteuerung FETs" ausgehend von der intelligenten Analogschaltung aus Figur 10 geschaltet. Dadurch wird sichergestellt, dass immer nur ein Kanal die Verbraucher versorgt, ebenso ist eine gegenseitige hardwaretechnische Verriegelung gewähr-

leistet. Ist das Ansteuerungssignal = Null/False, so versorgt der priorisierte erste Kanal die Verbraucher. Ist das Ansteuerungssignal = Eins/True, so versorgt der priorisierte zweite Kanal die Verbraucher.

In Figur 10 ist die analoge Ansteuerungsschaltung zur 2-Kanalversorgung von sicherheitsrelevanten Verbrauchern dargestellt. Diese gewährleistet eine intelligente Auswahl des Versorgungskanals. Die Verwendung von Operationsverstärkern (kurz: OPV, OP oder OpAmp) zur Messsignal-Aufbereitung bietet einige Vorteile. Hierzu zählt

- vernachlässigbar geringe Beeinflussung der zu messenden Schaltung,

- kleine Eingangsruheströme, diese liegen bei bipolaren OPVs bei 10 nA bis wenige 100 nA, bei FET-Eingangsstufen gehen diese Werte nahezu gegen 0 A,

- Reaktionszeit ist extrem schnell (analoge Schaltungstechnik).

Es ist dabei vorgesehen, dass anhand eines eingestellten Referenzspannungswertes, bspw. 13,5 V, eines Low-Power DC/DC-Converters der Versorgungskanal gewählt werden soll, das dessen Spannungsniveau die geringste Differenz zum Referenzspannungswert, bspw. 13,5 V, aufweist.

Die Ausführungsform hat den Vorteil, dass ein Fehlerfall des DC/DC-Ref bei Über- oder Unterspannung, durch einen Vergleich (V) gemäß Figur 6 abgefragt wird und im Zweifel den priorisierten fehlerfreien ersten Kanal schaltet.

Die intelligente Kanalauswahl basiert darauf, das bei zwei möglichen Versorgungskanälen jener gewählt wird, welcher näher an einem definierten Referenzwert (Gleichspannungsreferenz) liegt. Um dies zu ermitteln, muss zunächst die jeweilige Spannungsdifferenz zwischen dem ersten Kanal und der Gleichspannungsreferenz sowie dem zweiten Kanal und Gleichspannungsreferenz mittels eines Differenzenverstärkers gebildet werden.

Das resultierende Ergebnis des Differenzenverstärkers kann sowohl positiv als auch negativ ausfallen, daher muss zunächst der Betrag des Signals gebildet werden, erst dann kann die Auswertung mittels Komparator erfolgen. Ohne das Bilden des Betrages wäre die negative Spannung immer kleiner als die positive.

Beispiel ohne Betragsbildung (Figur 10):

erster Kanal CH-A = 12 V und zweiter Kanal CH-B = 14,5 V,
Nach Differenzenverstärker:

$$U_x = U_{CH\text{-}A} - U_{ref} = 12 \text{ V} - 13,5 \text{ V} = -1,5 \text{ V}$$

$$U_y = U_{CH\text{-}B} - U_{ref} = 14,5 \text{ V} - 13,5 \text{ V} = 1 \text{ V}$$

Würde jetzt die Komparator-Auswertung erfolgen, wäre Uy > Ux, es würde Ux und somit der erste Kanal die Verbraucher versorgen, was jedoch falsch wäre. Wenn der Betrag von Ux und Uy gebildet wird, wäre das Ergebnis des Komparators |Ux|>|Uy|, es würde Uy und somit der zweite Kanal B die Verbraucher versorgen, was richtig ist, da diese Spannung näher am Gleichspannungsreferenz-Wert liegt.

Bei der intelligenten Kanalauswahl muss zunächst mittels eines Differenzenverstärkers die Abweichung der einzelnen Kanalspannungen von der Referenzspannung ermittelt werden:

$$U_{CH\text{-}A} - U_{REF} = U_x \text{ bzw. } U_{CH\text{-}B} - U_{REF} = U_y$$

Zur weiteren Verarbeitung wird mittels einer Diodenschaltung der Betrag von |Ux| und |Uy| gebildet. Vorteilhaft bei der Verwendung von Dioden -> niedrige Kosten. Hierdurch ist es anschließend möglich, durch eine Komparatorschaltung den Kanal auszuwählen, der näher an der geforderten Referenzspannung ist. Das Ausgangssignal des Komparators steuert die selbstleitenden bzw. selbstsperrenden FETs im Laststrang vom ersten Kanal und vom zweiten Kanal. Eine mögliche Auswertung des Komparators könnte wie folgt sein: Komparator-Logik

|Ux| > |Uy|= 0 (Ansteuerung OFF)
|Ux| < |Uy|= 1 (Ansteuerung ON)

Durch die hardwaretechnische gegenseitige Verriegelung kann ein gleichzeitiges Schalten beider Kanäle vermieden werden.

Denkbar ist ebenso der Einsatz bei der Versorgung aus 3 oder 4 Kanälen, es wird hierzu auf Figur 5 verwiesen.

**Patentansprüche**

1. Schaltungsanordnung zum Durchführen eines Vergleichs zwischen einem ersten Signal und einem zweiten Signal unter Berücksichtigung eines Referenzsignals, wobei die Schaltungsanordnung (500, 1500)
   einen ersten Kanal (502, 1502), in dem das erste Signal bearbeitet wird, und einen zweiten Kanal (504, 1504), in dem das zweite Signal bearbeitet wird, wobei
   in dem ersten Kanal (502, 1502) ein erster Differenzverstärker (510, 1510), der eine erste Differenz zwischen dem ersten Signal und dem Referenzsignal bildet, und eine erste Einheit (514, 1514) zum Bilden eines Betrags, die einen ersten Betrag aus der ersten Differenz bildet, vorgesehen sind, und
   in dem zweiten Kanal (504, 1504)ein zweiter Differenzverstärker (512, 1512), der eine zweite Differenz zwischen dem zweiten Signal und dem Referenzsignal bildet, und eine zweite Einheit (516, 1516) zum Bilden eines Betrags, die einen zweiten Betrag aus der zweiten Differenz bildet, vorgesehen sind, und
   einen Komparator (518, 714, 1518), der den ersten Betrag mit dem zweiten Betrag vergleicht, umfasst, **dadurch gekennzeichnet, dass** die Schaltungsanordnung eine sicherheitsrelevante Komponente umfasst, wobei die Schaltungsanordnung dazu eingerichtet ist, eine redundante Spannungsversorgung für die sicherheitsrelevante Komponente bereitzustellen.

2. Schaltungsanordnung nach Anspruch 1, die dazu ausgebildet ist, in Abhängigkeit des durch den Komparator (518, 714, 1518) durchgeführten Vergleichs ein Ansteuersignal für ein Schaltelement (200, 300, 400) auszugeben.

3. Schaltungsanordnung nach Anspruch 1 oder 2, bei dem die Einheiten (514, 516, 1514, 1516) zum Bilden eines Betrags jeweils durch einen Diodengleichrichter (710, 712) gebildet sind.

4. Schaltungsanordnung nach einem der Ansprüche 1 bis 3, dem ein Referenzgleichspannungswandler (508, 1508) zum Ausgeben einer Referenzspannung zugeordnet ist.

5. Schaltungsanordnung nach einem der Ansprüche 1 bis 4, der ein Toggle-Gleichspannungswandler (506, 1506) zugeordnet ist.

6. Schaltungsanordnung nach Anspruch 5, der ein Vergleicher (522, 600, 1522) zugeordnet ist, der dazu eingerichtet ist, einen Schalter (527, 1527) zum Überbrücken des Toggle-Gleichspannungswandlers (506, 1506) anzusteuern.

7. Schaltungsanordnung nach einem der Ansprüche 1 bis 6, die zusätzlich über einen Schalter (523, 1523) nach dem Komparator (518, 714, 1518) verfügt, der dazu dient, ein bevorzugtes Signal zu bestimmen.

8. Schaltungsanordnung nach einem der Ansprüche 1 bis 7, der eine externe, unabhängige Spannungsquelle zum Bereitstellen einer Versorgung für den Komparator (518, 714, 1518) zugeordnet ist.

9. Verfahren zum Durchführen eines Vergleichs zwischen einem ersten Signal, und einem zweiten Signal unter Berücksichtigung eines Referenzsignals, wobei
   in einem ersten Kanal (502, 1502) das erste Signal und in einem zweiten Kanal (504, 1504) das zweite Signal bearbeitet wird, wobei
   in dem ersten Kanal (502, 1502) ein erster Differenzverstärker (510, 1510) eine erste Differenz zwischen dem ersten Signal und dem Referenzsignal bildet, und eine Einheit (514, 1514) zum Bilden eines Betrags einen ersten Betrag aus der ersten Differenz bildet, und
   in dem zweiten Kanal (504, 1504) ein zweiter Differenzverstärker (512, 1512) eine zweite Differenz zwischen dem zweiten Signal und dem Referenzsignal bildet und eine Einheit (516, 1516) zum Bilden eines Betrags einen zweiten Betrag aus der zweiten Differenz bildet, und
   ein Komparator (518, 714, 1518) den ersten Betrag mit dem zweiten Betrag vergleicht, **dadurch gekennzeichnet, dass** das Verfahren dazu eingesetzt wird, eine redundante Spannungsversorgung für eine sicherheitsrelevante Komponente bereitzustellen.

10. Verfahren nach Anspruch 9, bei dem in Abhängigkeit des durch den Komparator (518, 714, 1518) durchgeführten Vergleichs ein Schaltelement (200, 300, 400) angesteuert wird.

**11.** Verfahren nach Anspruch 9 oder 10, bei dem eines der beiden Signale als bevorzugtes Signal bestimmt wird.

**Claims**

**1.** Circuit arrangement for comparing a first signal and a second signal taking a reference signal into account, wherein the circuit arrangement (500, 1500) comprises
a first channel (502, 1502), in which the first signal is processed, and a second channel (504, 1504), in which the second signal is processed, wherein
a first differential amplifier (510, 1510), which forms a first difference between the first signal and the reference signal, and a first unit (514, 1514) for forming an absolute value, which forms a first absolute value from the first difference, are provided in the first channel (502, 1502), and
a second differential amplifier (512, 1512), which forms a second difference between the second signal and the reference signal, and a second unit (516, 1516) for forming an absolute value, which forms a second absolute value from the second difference, are provided in the second channel (504, 1504), and
a comparator (518, 714, 1518) which compares the first absolute value with the second absolute value, **characterized in that** the circuit arrangement comprises a safety-relevant component, wherein the circuit arrangement is configured to provide a redundant voltage supply for the safety-relevant component.

**2.** Circuit arrangement according to Claim 1, which is designed to output a control signal for a switching element (200, 300, 400) on the basis of the comparison carried out by the comparator (518, 714, 1518).

**3.** Circuit arrangement according to Claim 1 or 2, in which the units (514, 516, 1514, 1516) for forming an absolute value are each formed by a diode rectifier (710, 712) .

**4.** Circuit arrangement according to one of Claims 1 to 3, which is assigned a reference DC-DC converter (508, 1508) for outputting a reference voltage.

**5.** Circuit arrangement according to one of Claims 1 to 4, which is assigned a toggle DC-DC converter (506, 1506).

**6.** Circuit arrangement according to Claim 5, which is assigned a comparator (522, 600, 1522) which is configured to control a switch (527, 1527) for bridging the toggle DC-DC converter (506, 1506).

**7.** Circuit arrangement according to one of Claims 1 to 6, which additionally has a switch (523, 1523) downstream of the comparator (518, 714, 1518), which switch is used to determine a preferred signal.

**8.** Circuit arrangement according to one of Claims 1 to 7, which is assigned an external independent voltage source for providing a supply for the comparator (518, 714, 1518).

**9.** Method for comparing a first signal and a second signal taking a reference signal into account, wherein the first signal is processed in a first channel (502, 1502) and the second signal is processed in a second channel (504, 1504), wherein
a first differential amplifier (510, 1510) forms a first difference between the first signal and the reference signal and a unit (514, 1514) for forming an absolute value forms a first absolute value from the first difference in the first channel (502, 1502), and
a second differential amplifier (512, 1512) forms a second difference between the second signal and the reference signal and a unit (516, 1516) for forming an absolute value forms a second absolute value from the second difference in the second channel (504, 1504), and
a comparator (518, 714, 1518) compares the first absolute value with the second absolute value, **characterized in that** the method is used to provide a redundant voltage supply for a safety-relevant component.

**10.** Method according to Claim 9, in which a switching element (200, 300, 400) is controlled on the basis of the comparison carried out by the comparator (518, 714, 1518).

**11.** Method according to Claim 9 or 10, in which one of the two signals is determined as the preferred signal.

**Revendications**

1. Agencement de circuit permettant d'effectuer une comparaison entre un premier signal et un deuxième signal en tenant compte d'un signal de référence, l'agencement de circuit (500, 1500) comprenant

   un premier canal (502, 1502) dans lequel le premier signal est traité, et
   un deuxième canal (504, 1504) dans lequel le deuxième signal est traité, dans lequel
   dans le premier canal (502, 1502), un premier amplificateur différentiel (510, 1510) qui forme une première différence entre le premier signal et le signal de référence, et une première unité (514, 1514) pour former une valeur qui forme une première valeur à partir de la première différence sont prévus, et
   dans le deuxième canal (504, 1504), un deuxième amplificateur différentiel (512, 1512) qui forme une deuxième différence entre le deuxième signal et le signal de référence, et une deuxième unité (516, 1516) pour former une valeur qui forme une deuxième valeur à partir de la deuxième différence sont prévus, et
   un comparateur (518, 714, 1518) qui compare la première valeur à la deuxième valeur,
   **caractérisé en ce que** l'agencement de circuit comprend un composant important pour la sécurité, l'agencement de circuit étant aménagé pour fournir une alimentation en tension redondante pour le composant important pour la sécurité.

2. Agencement de circuit selon la revendication 1, qui est réalisé pour sortir un signal de pilotage pour un élément de circuit (200, 300, 400) en fonction de la comparaison effectuée par le comparateur (518, 714, 1518).

3. Agencement de circuit selon la revendication 1 ou 2, dans lequel les unités (514, 516, 1514, 1516) pour former une valeur sont formées respectivement par un redresseur à diodes (710, 712).

4. Agencement de circuit selon l'une quelconque des revendications 1 à 3, auquel est associé un convertisseur de tension continu-continu de référence (508, 1508) pour sortir une tension de référence.

5. Agencement de circuit selon l'une quelconque des revendications 1 à 4, auquel est associé un convertisseur de tension continu-continu à bascule (506, 1506).

6. Agencement de circuit selon la revendication 5, auquel est associé un comparateur (522, 600, 1522) qui est aménagé pour piloter un commutateur (527, 1527) pour ponter le convertisseur de tension continu-continu à bascule (506, 1506).

7. Agencement de circuit selon l'une quelconque des revendications 1 à 6, qui dispose en outre d'un commutateur (523, 1523) après le comparateur (518, 714, 1518) qui sert à déterminer un signal préféré.

8. Agencement de circuit selon l'une quelconque des revendications 1 à 7, auquel est associée une source de tension indépendante externe pour fournir une alimentation destinée au comparateur (518, 714, 1518).

9. Procédé permettant d'effectuer une comparaison entre un premier signal et un deuxième signal en tenant compte d'un signal de référence, dans lequel

   dans un premier canal (502, 1502), le premier signal est traité, et dans un deuxième canal (504, 1504), le deuxième signal est traité, dans lequel
   dans le premier canal (502, 1502), un premier amplificateur différentiel (510, 1510) forme une première différence entre le premier signal et le signal de référence, et une unité (514, 1514) pour former une valeur forme une première valeur à partir de la première différence, et
   dans le deuxième canal (504, 1504), un deuxième amplificateur différentiel (512, 1512) forme une deuxième différence entre le deuxième signal et le signal de référence, et une unité (516, 1516) pour former une valeur forme une deuxième valeur à partir de la deuxième différence, et
   un comparateur (518, 714, 1518) compare la première valeur à la deuxième valeur,
   **caractérisé en ce que** le procédé est mis en œuvre pour fournir une alimentation en tension redondante pour un composant important pour la sécurité.

10. Procédé selon la revendication 9, dans lequel un élément de circuit (200, 300, 400) est piloté en fonction de la comparaison effectuée par le comparateur (518, 714, 1518).

11. Procédé selon la revendication 9 ou 10, dans lequel l'un des deux signaux est déterminé comme un signal préféré.

Fig. 1

## Fig. 2

## Fig. 3

# Fig. 4

# Fig. 5

# Fig. 6

# Fig. 7

**Fig. 8**

**Fig. 9**

Fig. 10

**IN DER BESCHREIBUNG AUFGEFÜHRTE DOKUMENTE**

**In der Beschreibung aufgeführte Patentdokumente**

- DE 102009053691 A1
- WO 03049970 A1